# EUROPÄISCHE PATENTANMELDUNG

(11) **EP 2 637 400 A2**
(43) Veröffentlichungstag der Anmeldung: **11.09.2013**
(21) Anmeldenummer: 13157643.1
(22) Anmeldetag: 04.03.2013
(51) Int. Cl.: H04N 5/3745, H04N 13/02, H04N 5/225, H04N 5/369, H01L 27/146

(54) **Bildsensor und Verfahren zur Aufnahme eines Bildes**

(30) Priorität: 09.03.2012 EP 12158802
(71) Anmelder: SICK AG, 79183 Waldkirch (DE)
(72) Erfinder: Blöhbaum, Frank, 79312 Emmendingen (DE)
(74) Vertreter: Ludewigt, Christoph

(57) **Zusammenfassung**

Die Erfindung betrifft einen Bildsensor mit einem Lichtempfänger auf einem Substrat, auf dem wenigstens ein Array von Photodioden angeordnet ist. Zusätzlich sind auf dem Substrat elektronische Komponenten zur Verarbeitung der Signale der Photodioden angeordnet. Die elektronischen Komponenten weisen wenigstens einen Zähler auf und sind derart ausgebildet, dass für jede Photodiode ein dem Lichteinfall auf die Photodiode entsprechender Zählerwert erfasst wird. Über eine Lichtempfangsoptik wird ein Gesichtsfeld des Bildsensors auf den Lichtempfänger abgebildet. Um einen verbesserten Bildsensor bereitzustellen, sind die Photodioden auf dem Substrat in Subarrays gruppiert und die elektronischen Komponenten sind in den Zwischenräumen zwischen den Subarrays auf dem Substrat angeordnet. Die Lichtempfangsoptik ist weiter als Mikrolinsenarray ausgebildet und jede Mikrolinse bildet einen Teil des Gesichtsfeldes auf je ein Subarray ab. Schließlich ist eine Auswerteeinheit vorgesehen, um für jedes Subarray aus den erfassten Zählerständen ein Teilbild zu erstellen und um die Teilbilder der Subarrays zu einem Gesamtbild des Gesichtsfeldes zusammenzusetzen.

## Beschreibung

Die Erfindung betrifft einen Bildsensor nach dem Oberbegriff des Anspruchs 1 und ein Verfahren zur Aufnahme eines Bildes.

Ein derartiger Bildsensor ist aus der EP 0 631 680 B1 oder aus dem Artikel "Belichtungsregelung individueller Pixel von CMOS-Bildsensoren", Photonic 4/2007, S. 80, bekannt. Diese Dokumente beschreiben einen Bildsensor mit pixelnaher Verarbeitung der Signale, wobei möglichst früh in der Signalkette eine Umwandlung der Photodiodensignale in digitale Signale erfolgt. Dadurch lässt sich eine hohe Dynamik von bis zu 120 dB erreichen. Details bei kontrastreichen Lichtverhältnissen können dann besser erfasst werden. Herkömmliche analoge Bildsensoren mit linearer Charakteristik erreichen nur eine Dynamik von ca. 60 dB.

Ein großer Nachteil von Bildsensoren z.B. mit erweitertem Dynamikbereich nach EP 0 631 680 B1 ist jedoch der sehr kleine Füllfaktor. Er beträgt typischerweise 2 %, nur ein kleiner Teil des Lichtes fällt überhaupt auf die lichtempfindlichen Photodiodenflächen, wohingegen der Großteil des Lichts auf die restliche, nichtphotoaktive Fläche fällt. Dadurch ist die Empfindlichkeit eines solchen Bildsensors für viele Anwendungen zu gering und es geht Bildinformation in großem Maße verloren.

Ausgehend von diesem Stand der Technik ist es Aufgabe der Erfindung, einen verbesserte Bildsensor und ein verbessertes Verfahren zur Aufnahme eines Bildes bereitzustellen.

Diese Aufgabe wird gelöst durch einen Bildsensor mit den Merkmalen des Anspruchs 1 und ein Verfahren mit den Merkmalen des Anspruchs 5.

Der erfindungsgemäße Bildsensor umfasst einen Lichtempfänger auf einem Substrat, auf dem wenigstens ein Array von Photodioden angeordnet ist. Zusätzlich sind auf dem Substrat elektronische Komponenten zur Verarbeitung der Signale der Photodioden angeordnet. Die elektronischen Komponenten weisen wenigstens einen Zähler auf und sind derart ausgebildet, dass für jede Photodiode ein dem Lichteinfall auf die Photodiode entsprechender Zählerwert erfasst wird. Über eine Lichtempfangsoptik wird ein Gesichtsfeld des Bildsensors auf den Lichtempfänger abgebildet. Erfindungsgemäß sind die Photodioden auf dem Substrat in Subarrays gruppiert und die elektronischen Komponenten sind in den Zwischenräumen zwischen den Subarrays auf dem Substrat angeordnet. Die Lichtempfangsoptik ist weiter als Mikrolinsenarray ausgebildet und jede Mikrolinse bildet einen Teil des Gesichtsfeldes auf je ein Subarray ab. Schließlich ist eine Auswerteeinheit vorgesehen, um für jedes Subarray aus den erfassten Zählerständen ein Teilbild zu erstellen und um die Teilbilder der Subarrays zu einem Gesamtbild des Gesichtsfeldes zusammenzusetzen.

Die Aufgabe wird erfindungsgemäß gelöst mit einem Verfahren zur Aufnahme eines Bildes mit den folgenden Schritten:
- Abbilden von Empfangslicht aus einem Gesichtsfeld mit einem Mikrolinsenarray auf Subarrays von Photodioden eines Lichtempfängers, so dass eine Mikrolinse jeweils einen Teil des Gesichtsfeldes auf ein Subarray abbildet,
- für jede Photodiode Vergleichen der Photodiodenspannung mit einer Referenzspannung mit Hilfe eines Komparators,
- Erfassen des Umschaltens des Komparators mittels eines Zählers,
- Bereitstellen des Zählerstands beim Umschaltzeitpunkt,
- Erfassen des Zählerstands in einer Folgeelektronik,
- Erstellen von Teilbildern aus den Zählerständen, die den einzelnen Photodioden eines Subarrays zugeordnet sind,
- Zusammensetzen eines Gesamtbildes aus den Teilbildern.

Der wesentliche Vorteil ist, dass mit der Erfindung der Füllfaktor erheblich gesteigert werden kann und zwar bis in Bereiche von >90 %. Durch die Ausbildung des Bildsensors als sogenannte Multiapertur-Kamera mit Gruppierung der Photodioden zu Subarrays und Zuordnung der Mikrolinsen zu den Subarrays kann erreicht werden, dass ein wesentlich höherer Anteil des Lichts aus dem Gesichtsfeld auf die Photodioden abgebildet wird und nicht ungenutzt die Zwischenräume zwischen den Subarrays beleuchtet.

Weiter können die Vorteile der pixelnahen Digitalisierung voll ausgenutzt werden, denn zwischen den Subarrays ist ausreichend Platz für die pixelnahe analoge und digitale Signalverarbeitung. Ein weiterer Vorteil ist die Minimierung der kritischen Leitungslängen zwischen den Photodioden und ihrer zugehörigen Signalverarbeitungseinheit, die der direkten Digitalisierung des Photostromes dient. Daraus resultieren geringere parasitäre Kapazitäten, die das tatsächliche Chipdesign für einen rauscharmen und gleichzeitig hoch getakteten Bildsensor wesentlich vereinfachen.

Des Weiteren werden zusätzlich die Vorteile einer Multiapertur-Kamera, nämlich die äußerst geringe Bautiefe von z. B. kleiner 2 mm und der insgesamt sehr kleinen möglichen Bauform, erhalten.

Der erfindungsgemäße Bildsensor, bestehend aus Sensorchip und zugehöriger Mikrooptik, stellt ein photonisches Mikrosystem dar, das auf Grund seiner geringen Bautiefe kostensparend im Waferlevelmaßstab hergestellt werden kann.

In einer ersten Ausführungsform ist jeder Photodiode ein Zähler zugeordnet.

Um Komponenten und damit auch Bauraum zu sparen, kann in einer weiteren Ausführungsform immer einer Gruppe von Photodioden, vorzugsweise einem Subarray, jeweils ein Zähler zugeordnet sein und jeder Photodiode ein Latch. Die jeweiligen den einzelnen Photodioden entsprechenden Zählerstände werden abhängig vom entsprechenden Komparatorschaltsignal jeweils in das der jeweiligen Photodiode zugeordnete Latch übertragen und dort festgehalten. Je nach Ausführungsform und Erfordernis eines optimalen Chipdesigns kann jedem Subarray je ein Zähler zugeordnet sein, es können aber auch andere Zuordnungen erfolgen wie z.B. zwei Zähler zu einem Subarray oder zwei oder vier benachbarte Subarrays zu einem Zähler.

Für die unmittelbare Digitalisierung des Photodiodensignals ist jeder Photodiode unmittelbar ein Komparator zugeordnet und dem Komparator wird wiederum der Zähler und/oder das Latch nachgeordnet.

Die Erfindung wird nachstehend anhand eines Ausführungsbeispiels unter Bezugnahme auf die beigefügte Zeichnung näher erläutert. In der Zeichnung zeigen:
- Fig. 1: eine schematische Seitendarstellung eines erfindungsgemäßen Bildsensors,
- Fig. 2: eine Draufsicht auf das Substrat des Bildsensors,
- Fig. 3: eine Ausführungsform der pixelnahen Signalverarbeitung,
- Fig. 4: ein Diagramm, Photodiodenspannung gegen Zeit, zur Verdeutlichung des Funktionsprinzips der Signalverarbeitung,
- Fig. 5: eine weitere Ausführungsform der pixelnahen Signalverarbeitung.

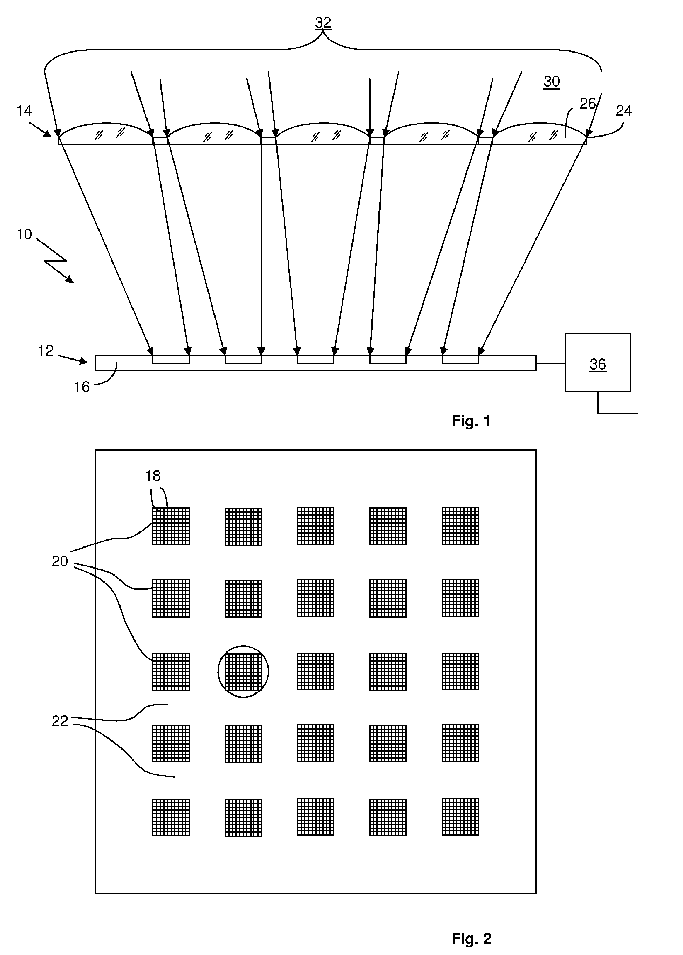

In Fig. 1 ist ein erfindungsgemäßer Bildsensor 10 dargestellt, der einen Lichtempfänger 12 und eine Lichtempfangsoptik 14 aufweist. Der Lichtempfänger 12, der in Fig. 2 in der Draufsicht dargestellt ist, umfasst ein Substrat 16, auf dem eine Vielzahl, also typischerweise ein Array, von Photodioden 18 angeordnet ist. Die Photodioden 18 sind auf dem Substrat 16 in Subarrays 20 gruppiert, beispielsweise je 20 x 20 oder 40 x 40 Photodioden.

Die Lichtempfangsoptik 14 ist als Mikrolinsenarray 24 ausgebildet. Jede Mikrolinse 26 des Mikrolinsenarrays 24 bildet einen Teil 30 des Gesamtgesichtsfeldes 32 auf je ein Subarray 20 ab, so dass insgesamt das Gesamtgesichtsfeld 32 des Bildsensors 10 auf den Lichtempfänger 12 abgebildet wird. In der Draufsicht in Fig. 2 ist mit dem Bezugszeichen 34 eine solche Abbildung des Lichts eines Teils des Gesichtsfeldes auf eines der Subarrays 20 dargestellt.

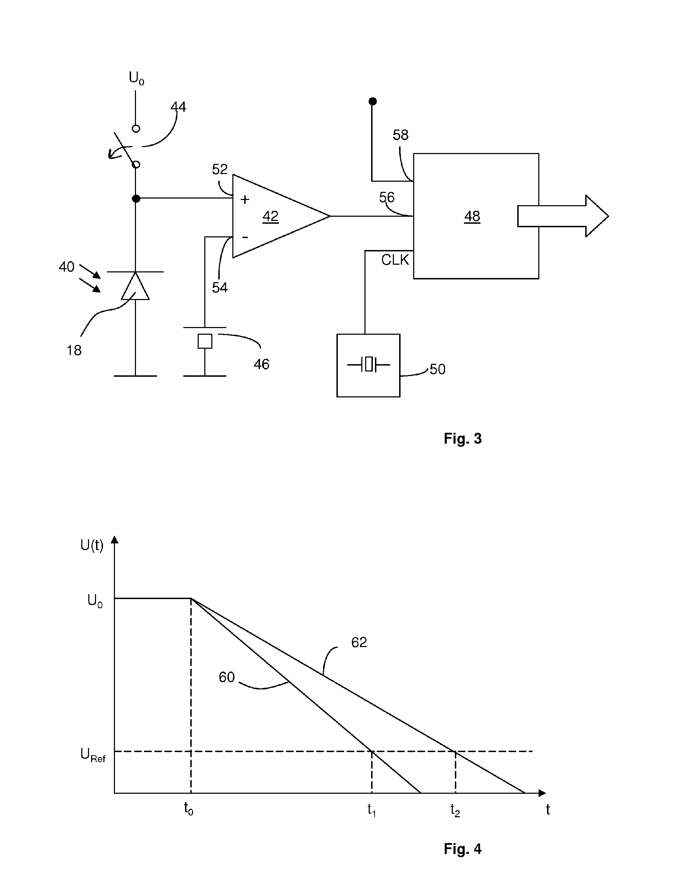

Zwischen den Subarrays 20 sind Zwischenräume 22 gelassen. In diesen Zwischenräumen 22 sind elektronische Komponenten, die unter Bezugnahme auf Fig. 3 weiter unten näher erläutert werden, angeordnet. Diese Komponenten dienen zur pixelnahen Verarbeitung der Signale der Photodioden 18.

Wie Fig. 1 und 2 andeuten, wird Licht auf jeweils ein Subarray 20 abgebildet, so dass aus den Signalen der Photodioden 18 eines jeden Subarrays 20 ein Teilbild erzeugbar ist. Ein solches Teilbild wird vorzugsweise in einer Auswerteeinheit 36 erstellt. Aus den einzelnen Teilbildern wird ebenfalls in der Auswerteeinheit 36 ein Gesamtbild des Gesichtsfeldes zusammengesetzt.

Zur Erzeugung eines Teilbildes müssen die von dem einfallenden Licht 40 in den Photodioden 18 erzeugten Photoströme bzw. Photospannungen ausgelesen werden. Dies wird im Folgenden anhand der Fig. 3 und 4 erläutert.

Die bereits erwähnten elektronischen Komponenten zur pixelnahen Signalverarbeitung sind auf dem Substrat 16 in den Zwischenräumen 22 angeordnet. In einer ersten Ausführungsform umfassen diese Komponenten je Photodiode 18 einen Komparator 42, einen Schalter 44, eine Referenzspannungsquelle 46, einen Zähler 48 und einen Taktgeber 50.

Ein Anschluss der Photodiode 18 ist einerseits über den Schalter 44 an einem Potential U₀ angelegt und andererseits an einen Eingang 52 des Komparators 42. An dem anderen Komparatoreingang 54 liegt eine von der Referenzspannungsquelle 46 erzeugte Referenzspannung U_{Ref} an. Der Ausgang des Komparators 42 liegt am Eingang 56 des Zählers 48. Der Zähler 48 erhält seinen Takt von dem Taktgeber 50. Über einen Reset-Eingang 58 ist der Zähler 48 rücksetzbar.

Bei Start einer Bildaufnahme zum Zeitpunkt t₀ wird der Schalter 44 geöffnet und zeitgleich der Zähler 48 freigegeben. Der Zähler 48 startet dabei mit einem definierten Zählerstand, der z.B. mittels eines Rücksetzvorganges über den Rücksetzeingang 58 erzeugt werden kann. Denkbar ist auch der Start von einem vorher in den Zähler geladenen Zählerstand aus, der vom Zählerstand null definiert abweicht.

Mit dem Öffnen des Schalters 44 liegt die volle Spannung U₀ am Komparator an. Je nach Intensität des einfallenden Lichts 40 auf die Photodiode 18 erfolgt ein Absinken der Spannung U(t). Ist der Lichteinfall groß, erfolgt ein schnelleres Absinken entsprechend dem Verlauf 60 und ein früheres Erreichen der Referenzspannung U_{Ref} bei t₁. Bei kleinerem Lichteinfall sinkt die Spannung U(t) langsamer, was durch den Verlauf 62 angedeutet ist. Die Referenzspannung U_{Ref} wird später bei t₂ erreicht. Erreicht die Spannung U(t) den Wert der Referenzspannung U_{Ref} schaltet der Komparator 42 um, was ein Stoppen des Zählers 48 und/oder einen Übertrag des Zählerstandes in ein Latch auslöst. Dann ist der Zählerstand für jede Photodiode ein Maß für den Lichteinfall auf die Photodiode. Der Zählerstand wird in einer Folgeelektronik zur weiteren Auswertung erfasst.

Damit hat jede Photodiode ihre eigene Belichtungszeit (also jeder Zähler seine eigene "Integrationszeit"), nämlich bis die Photodiodenspannung auf U_{Ref} abgefallen ist. Es gibt keine globale Integrationszeit. Selbstverständlich kann die einzelne Belichtungszeit nur so entsprechend groß sein wie die Zählertiefe. Ist die Spannung am Komparatoreingang 52 bei Erreichen des Zählerhöchststandes noch nicht auf U_{Ref} abgesunken, wird gestoppt und das Pixel als "schwarz" bewertet.

Aus den einzelnen Zählerständen, die der Intensität des auf die jeweilige Photodiode 18 einfallenden Lichts 40 entsprechen, kann dann in der Auswerteeinheit 36 ein Bild für ein Subarray erstellt werden, das einem Teilbild des gesamten Bildes des Gesichtsfelds 32 entspricht. Aus den Teilbildern kann im Weiteren in der Auswerteeinheit ein Gesamtbild erstellt werden.

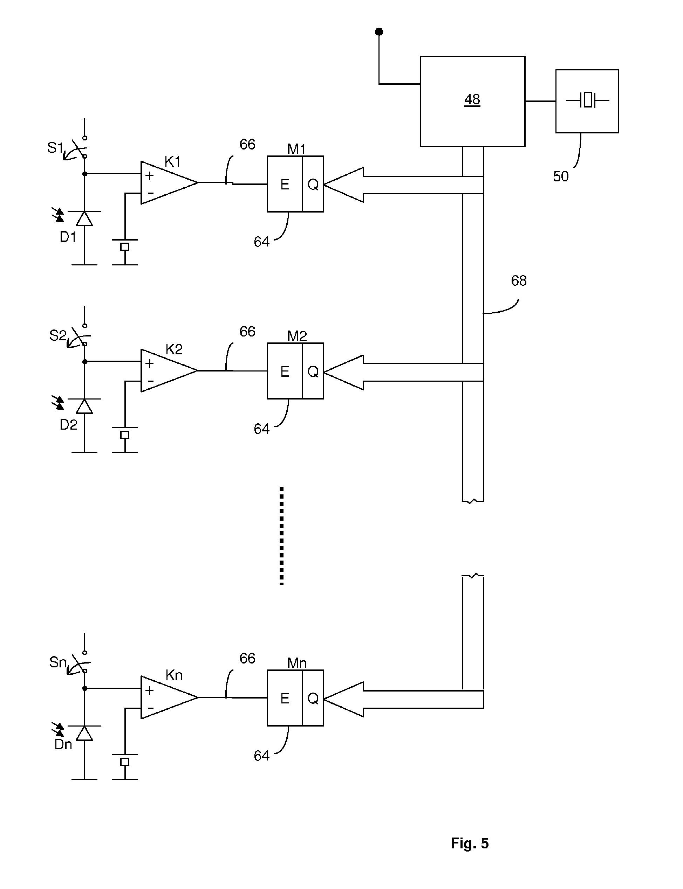

In einer weiteren Ausführungsform der Signalverarbeitung, die in Fig. 5 schematisch dargestellt ist, ist jeweils nur ein Zähler 48 immer einer Gruppe von n Photodioden 18 (D1 bis Dn), vorzugsweise eines Subarrays 20, zugeordnet. Jeder Photodiode 18 (D1 bis Dn) mit dem ihr jeweils zugehörigen Komparator 42 (K1 bis Kn) ist ein Speicher 64 (M1 bis Mn) zugeordnet. Die Zuordnung ist durch separate Verbindungslinien 66 angedeutet. Der jeweilige Speicher 64, der vorzugsweise als Latch ausgeführt ist, dient der Erfassung und Speicherung des der Photodiode zugeordneten Zählerstandes, so dass die Auswertung und Erstellung eines Bildes wie zuvor beschrieben über die Zählerstände erfolgen kann. Der mit dem Öffnen der Schalter S1 bis Sn für n Photodioden synchron gestartete Zähler 48 wird wieder von der Takteinheit 50 getaktet. Der Ausgang des Zählers 48 legt den Zählerstand über eine parallel oder seriell ausgeführte Busleitung 68 an die Speicher M1 bis Mn (für n Photodioden) an. Erreicht die Photodiodenspannung am jeweils zugeordneten Komparatoreingang 52 den Spannungswert U_{Ref}, so schaltet der Komparator seinen Ausgang um (Potentialwechsel). Über die Leitung 66 wird über den Enable-Eingang E des zugeordneten Speichers 64 der am Port Q anliegende Zählerstand des Zählers 48 abgespeichert. Der Vorteil dieser Ausführungsform besteht in der kompakteren Ausbildung, denn als Latch ausgeführte Speicher haben erheblich weniger Platzbedarf auf einem Substrat als die entsprechende Anzahl Zähler.

In einer weiteren nicht dargestellten Ausführungsform wäre es denkbar, den Schalter 44 und die Photodiode 18 so in die Schaltung einzubauen, dass bei Lichteinfall die Spannung U(t) nicht abfällt, sondern steigt. Die Referenzspannung hätte dann einen entsprechend höheren Wert.

In einer weiteren nicht dargestellten Ausführungsform verfügt der Zähler 48 neben einem Reset-Eingang zusätzlich über einen Enable-Eingang, so dass das Zurücksetzen des Zählers zeitlich vor dem Start der Bilderfassung erfolgen kann und der mit dem Öffnen der Photodioden-Schalter 44 synchrone Start des Zählers über den Enable-(=Zählfreigabe-) Eingang erfolgt.

In einer weiteren bevorzugten Ausführung wird das gesamte Timing der erfindungsgemäßen Anordnung inklusive Öffnen und Schließen der Schalter 44 und Reset-und/oder Enable-Eingang des Zählers von einer zentralen Takteinheit synchron gesteuert.

## Patentansprüche

1. Bildsensor
- mit einem Lichtempfänger auf einem Substrat, auf dem wenigstens ein Array von Photodioden angeordnet ist,
- mit auf dem Substrat angeordneten elektronischen Komponenten zur Verarbeitung der Signale der Photodioden, wobei
- die elektronischen Komponenten wenigstens einen Zähler aufweisen und derart ausgebildet sind, dass für jede Photodiode ein dem Lichteinfall auf die Photodiode entsprechender Zählerwert erfasst wird und
- mit einer Lichtempfangsoptik, die ein Gesichtsfeld auf den Lichtempfänger abbildet,
**dadurch gekennzeichnet,**
- **dass** die Photodioden auf dem Substrat in Subarrays gruppiert sind und die elektronischen Komponenten zwischen den Subarrays auf dem Substrat angeordnet sind und
- **dass** die Lichtempfangsoptik als Mikrolinsenarray ausgebildet ist und jede Mikrolinse einen Teil des Gesichtsfeldes auf je ein Subarray überträgt und
- **dass** eine Auswerteeinheit vorgesehen ist, die ausgebildet ist, um für jedes Subarray aus den erfassten Zählerständen ein Teilbild zu erstellen und um die Teilbilder der Subarrays zu einem Bild des Gesichtsfeldes zusammenzusetzen.

2. Bildsensor nach Anspruch 1, **dadurch gekennzeichnet, dass** jeder Photodiode ein Zähler zugeordnet ist.

3. Bildsensor nach einem der vorhergehenden Ansprüche, **dadurch gekennzeichnet, dass** immer einer Gruppe von Photodioden, vorzugsweise einem Subarray, jeweils ein Zähler zugeordnet ist und jeder Photodiode ein Speicher, der vorzugsweise als Latch ausgebildet ist, zugeordnet ist.

4. Bildsensor nach einem der vorhergehenden Ansprüche, **dadurch gekennzeichnet, dass** jeder Photodiode unmittelbar ein Komparator zugeordnet ist und dem Komparator der Zähler nachgeordnet ist.

5. Verfahren zur Aufnahme eines Bildes mit den Schritten:
- Abbilden von Empfangslicht aus einem Gesichtsfeld mit einem Mikrolinsenarray auf Subarrays von Photodioden eines Lichtempfängers, so dass eine Mikrolinse jeweils einen Teil des Gesichtsfeldes auf ein Subarray abbildet,
- für jede Photodiode Vergleichen der Photodiodenspannung mit einer Referenzspannung mit einem Komparator,
- Erfassen des Umschaltens des Komparators mittels eines Zählers,
- Bereitstellen des Zählerstands beim Umschaltzeitpunkt,
- Erfassen des Zählerstands in einer Folgeelektronik,
- Erstellen von Teilbildern aus den Zählerständen, die den einzelnen Photodioden eines Subarrays zugeordnet sind,
- Zusammensetzen eines Gesamtbildes aus den Teilbildern.
